Europäisches Patentamt

European Patent Office

Office européen des brevets

(11) Publication number: **0 356 039**
**A1**

# EUROPEAN PATENT APPLICATION

(21) Application number: 89307848.5

(51) Int. Cl.⁴: **H01L 29/784 , H01L 27/088**

(22) Date of filing: 02.08.89

The title of the invention has been amended (Guidelines for Examination in the EPO, A-III, 7.3).

(30) Priority: **19.08.88 JP 206988/88**

(43) Date of publication of application:
**28.02.90 Bulletin 90/09**

(84) Designated Contracting States:
**DE FR GB NL**

(71) Applicant: **SEIKO EPSON CORPORATION**
**4-1, Nishishinjuku 2-chome**
**Shinjuku-ku Tokyo-to(JP)**

(72) Inventor: **Takenaka, Kazuhiro**
**Seiko Epson Corporation 3-5 Owa 3-chome**
**Suwa-shi Nagano-ken(JP)**

(74) Representative: **Caro, William Egerton et al**
**J. MILLER & CO. Lincoln House 296-302 High**
**Holborn**
**London WC1V 7JH(GB)**

(54) **MOS semiconductor integrated circuit.** ·

(57) A semi-conductor device has an internal circuit incorporating an N-channel MOS transistor (105) and a peripheral circuit including an N-channel MOS transistor (106). A drain diffusion layer (109) of the transistor (106) of the peripheral circuit has a phosphorus concentration which is higher than the phosphorus concentration of a drain diffusion layer (108) of the transistor (105) of the internal circuit.

FIG. 1

## SEMI-CONDUCTOR DEVICE

This invention relates to semi-conductor devices.

To protect against an external surge input such as static electricity, a conventional semi-conductor device has a protection circuit composed of a combination of various resistors, such as diffusion resistors and poly-crystalline silicon resistors, diodes and transistors provided between a bonding pad portion and internal circuitry.

However, transistors have recently become smaller and smaller. In an LDD (lightly doped drain) structure a drain diffusion layer is composed of a high concentration arsenic diffusion layer and a low concentration phosphorus diffusion layer. In a double diffusion structure a low concentration region is provided by utilising the difference in diffusion coefficient between arsenic and phosphorus. Both structures have been adopted in order to reduce hot carrier effect in a transistor having a channel length of not more than 2 microns. Development of such miniaturisation of transistors and the adoption of a drain structure having a low concentration region (see e.g. C. Duvvury, R. A. Mcphee, D. A. Baglee and R. N. Rountree "ESD Protection Reliability in 1 micron CMOS Technologies" in Proc. IRPS, pp 199 to 205 (1986)) together with the tendency to reduce channel length, means that the ability of the transistor itself to withstand a surge input is reduced and conventional techniques for protecting transistors against surge input are insufficient. The output terminal of a transistor for direct connection between the drain of the transistor and a bonding pad, is greatly affected by the reduced ability of the transistor to withstand a surge input whose voltage is then equal to the voltage of surge input that the output terminal is able to withstand.

The present invention seeks to provide a semi-conductor device which is composed of minute transistors and which yet has sufficient protection against surge input.

According to one aspect of the present invention, there is provided a semi-conductor device having an internal circuit including an N-channel MOS transistor and a peripheral circuit including an N-channel MOS transistor characterised in that a drain diffusion layer of the transistor of the peripheral circuit has a phosphorus concentration which is higher than the phosphorus concentration of a drain diffusion layer of the transistor of the internal circuit.

In one embodiment the drain diffusion layers of the transistors of the internal and peripheral circuits have a double diffusion structure composed of arsenic and phosphorus. Preferably in this embodiment the transistor in the internal circuit is provided with said double diffusion structure by doping phosphorus ions at a dosage of not more than 1 x $10^{14}$ cm$^{-2}$ and arsenic ions at a dosage of not less than 2 x $10^{15}$ cm$^{-2}$, and the transistor in the peripheral circuit is provided with said double diffusion structure by doping phosphorus ions at a dosage of not more than 1 x $10^{14}$ cm$^{-2}$ and arsenic ions at a dosage of not less than 2 x $10^{15}$ cm$^{-2}$.

In another embodiment the drain diffusion layers of the transistors of the internal and peripheral circuits have an LDD structure composed of arsenic and phosphorus.

Preferably in this embodiment the transistor in the internal circuit is provided with said LDD structure by doping phosphorus ions at a dosage of not more than 2 x $10^{13}$ cm$^{-2}$ and arsenic ions at a dosage of not less than 2 x $10^{15}$ cm$^{-2}$, and the transistor in the peripheral circuit is provided with said LDD structure by doping phosphorus ions at a dosage of more than 2 x $10^{13}$ cm$^{-2}$ and arsenic ions at a dosage of not less than 2 x $10^{15}$ cm$^{-2}$.

The channel length of the transistor in the peripheral circuit may be larger than the channel length of the transistor in the internal circuit.

According to another aspect of the present invention, there is provided a semi-conductor device having an internal circuit including a MOS transistor and a peripheral circuit including a MOS transistor characterised in that a drain diffusion layer of the transistor of the peripheral circuit has an impurity concentration which is higher than the impurity concentration of a drain diffusion layer of the transistor of the internal circuit.

According to a further aspect of the present invention, there is provided a method of making a semi-conductor device as recited above.

The invention is illustrated, merely by way of example, in the accompanying drawings, in which:-

Figure 1 is a sectional view of a main part of an embodiment of a semi-conductor device according to the present invention;

Figure 2 shows the relationship between the amount of phosphorus implantation and degradation due to hot carriers and electro-static withstand voltage in the case of a double diffusion structure;

Figure 3 is a sectional view of a main part of another embodiment of a semi-conductor device according to the present invention; and

Figure 4 shows the relationship between the amount of phosphorus implantation and degradation due to hot carriers and electro-static withstand voltage in the case of adopting an LDD structure.

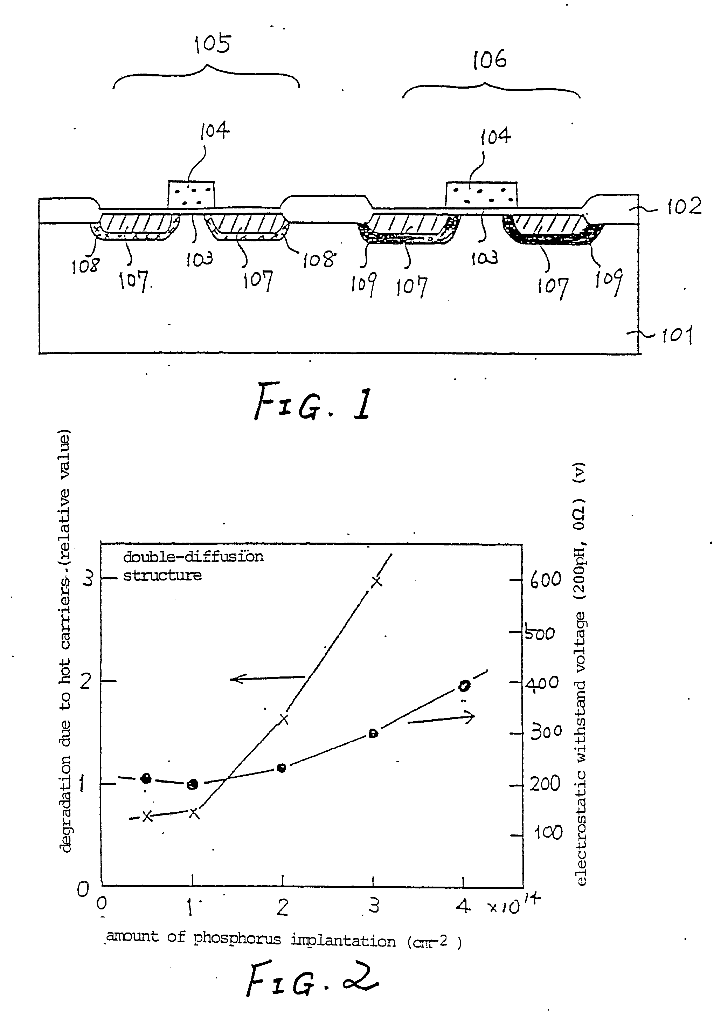

Referring first to Figure 1 there is illustrated one embodiment of a semi-conductor device according to the present invention. In this embodiment, N-channel transistors having a double diffusion structure are used.

A P-type silicon substrate 101 has a resistivity of, for example, 10 ohm.cm. An insulation film 102 separates elements and is formed by, for example, a LOCOS process. A gate oxide film 103 is formed to a thickness of about 300 Angstroms by, for example, thermal oxidation. Gate electrodes 104 are composed of a material such as poly-crystalline silicon. A transistor 105 constitutes an internal circuit and a transistor 106 constitutes a peripheral circuit. An N-type high concentration diffusion layer 107 constitutes a drain diffusion layer and is formed by, for example, doping arsenic ions at a dosage of $5 \times 10^{15}$ cm$^{-2}$. An N-type low concentration diffusion layer 108 constitutes a drain diffusion layer of the transistor 105 and is formed by, for example, doping phosphorus ions at a dosage of $1 \times 10^{14}$ cm$^{-2}$. An N-type low concentration diffusion layer 109 constitutes a drain diffusion layer of the transistor 106 and is formed by, for example, doping phosphorus ions at a dosage of $3 \times 10^{14}$ cm$^{-2}$. The phosphorus diffusion layer 109 may be provided either separately from the diffusion layer 108 or by separate phosphorus ion implantation only on the transistor 106 after the diffusion layer 108 has been provided.

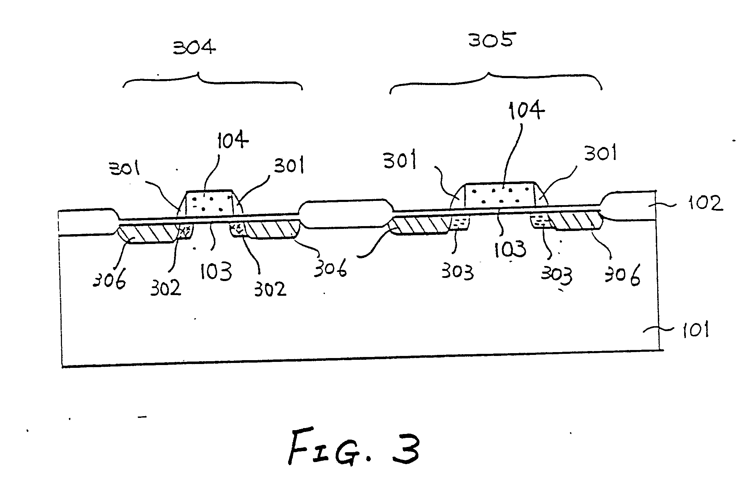

Deterioration due to hot carriers and electrostatic withstand voltage i.e. the voltage of a surge input that a transistor has the ability to withstand, with respect to the amount of phosphorus implantation in the case of a double diffusion structure, is illustrated in Figure 2. With reduction in channel length, degradation due to hot carriers increases. The degradation due to hot carriers depends upon the amount of phosphorus implantation, as shown in Figure 2, and the degradation is the least when the phosphorus implantation is about $1 \times 10^{14}$ cm$^{-2}$ and it increases with increase in the amount of phosphorus implantation. In contrast, the electrostatic withstand voltage is the least when the phosphorus implantation is about $1 \times 10^{14}$ cm$^{-2}$. Accordingly, it is possible to obtain a semi-conductor device which not only is able to withstand degradation due to hot carriers but also has a large electrostatic withstand voltage by doping phosphorus ions in the transistor 105 which may be subject to a surge input, e.g. static electricity, at about $1 \times 10^{14}$ cm$^{-2}$ and protect against degradation due to hot carriers by doping phosphorus ions in the transistor 106 at, for example, $3 \times 10^{14}$ cm$^{-2}$. The degradation of the transistor 106 can be reduced to a substantially negligible level by, for example, making its channel length larger than the channel length of the transistor 105.

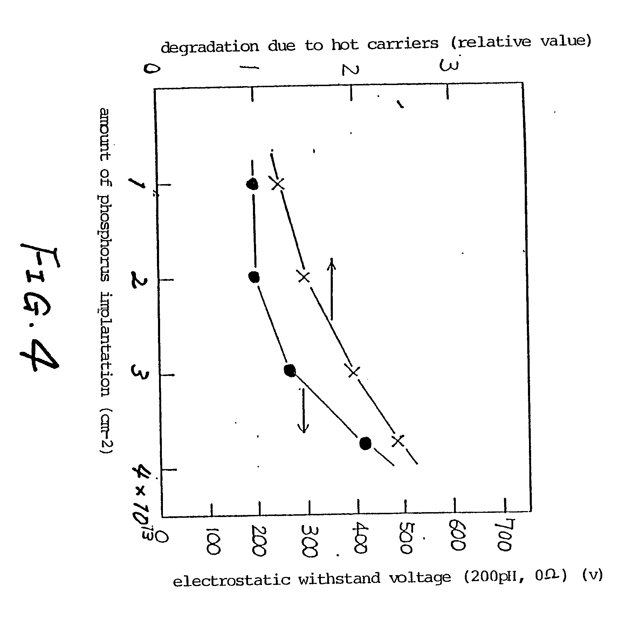

Although this embodiment adopts N-channel transistors having a double diffusion structure, the same effect is obtained by using an N-channel transistor having an LDD structure. This is illustrated in Figure 3 which is a sectional view of another embodiment of a semi-conductor device according to the present invention. Like parts in Figures 1 and 3 have been designated by the same reference numerals. The semi- conductor device of Figure 3 has an N-channel transistor 304 in an internal circuit and an N-channel transistor 305 in a peripheral circuit. A side wall 301 constituting an LDD structure is provided by forming, for example, silicon dioxide on the entire surface of the insulating film 102 and then etching it back.

Reference numerals 302, 303 denote low concentration diffusion layers in the internal circuit and the peripheral circuit, respectively. These diffusion layers 302, 303 are formed by, for example, ion implantation, before the formation of the side wall 301.

A high concentration diffusion layer 306 is provided by, for example, doping arsenic ions at a dosage of $5 \times 10^{15}$ cm$^{-2}$. In the case of an LDD structure, the amount of ion implantation for the formation of the low concentration diffusion layers 302, 303 is less than in the case of a double diffusion structure. For example, if phosphorus ions are doped at a dosage of $1.8 \times 10^{13}$ cm$^{-2}$ to form the low concentration diffusion layer 302 of the transistor 304 and at a dosage of $3 \times 10^{13}$ cm$^{-2}$ to form the low concentration diffusion layer 303 of the transistor 305 in the peripheral circuit, it is possible to fabricate a semi-conductor device which suffers little degradation due to hot carriers and has a sufficient electro-static withstand voltage.

Figure 4 illustrates the relationship between the amount of the phosphorus implantation and degradation due to hot carriers and electro-static withstand voltage.

As in the first embodiment described in relation to Figures 1 and 2, it is possible to fabricate a semi-conductor device with reduced degradation due to hot carriers by making the channel length of the transistor 305 in the peripheral circuit larger than the channel length of the transistor 304 in the internal circuit. The correlation between channel length and electro-static withstand voltage is not very high, and when the channel length is large, the electro-static withstand voltage becomes higher. This phenomenon is the same with a double diffusion structure of semi-conductor device.

Although the present invention has been described only in relation to embodiments with N-channel transistors, the present invention is also applicable to semi-conductor devices composed of N-channel and P-channel transistors, or bi-polar and N-channel transistors.

As described above, a semi-conductor device according to the present invention can be protected against degradation by hot carriers and provided with an improved ability to withstand an external surge input such as static electricity by making the phosphorus concentration in the N-channel transistor or transistors in the peripheral circuit higher than the phosphorus concentration in the N-channel transistor or transistors in the internal circuit.

## Claims

1. A semi-conductor device having an internal circuit including an N-channel MOS transistor (105, 304) and a peripheral circuit including an N-channel MOS transistor (106, 305) characterised in that a drain diffusion layer (109, 303) of the transistor (106, 305) of the peripheral circuit has a phosphorus concentration which is higher than the phosphorus concentration of a drain diffusion layer (108, 302) of the transistor (105, 304) of the internal circuit.

2. A semi-conductor device as claimed in claim 1 characterised in that the drain diffusion layers (108, 109) of the transistors of the internal and peripheral circuits have a double diffusion structure composed of arsenic and phosphorus.

3. A semi-conductor device as claimed in claim 2 characterised in that the transistor (105) in the internal circuit is provided with said double diffusion structure by doping phosphorus ions at a dosage of not more than $1 \times 10^{14}$ cm$^{-2}$ and arsenic ions at a dosage of not less than $2 \times 10^{15}$ cm$^{-2}$, and the transistor (106) in the peripheral circuit is provided with said double diffusion structure by doping phosphorus ions at a dosage of not more than $1 \times 10^{14}$ cm$^{-2}$ and arsenic ions at a dosage of not less than $2 \times 10^{15}$ cm$^{-2}$.

4. A semi-conductor device as claimed in claim 1 characterised in that the drain diffusion layers (302, 303) of the transistors of the internal and peripheral circuits have an LDD structure composed of arsenic and phosphorus.

5. A semi-conductor device as claimed in claim 4 characterised in that the transistor (304) in the internal circuit is provided with said LDD structure by doping phosphorus ions at a dosage of not more than $2 \times 10^{13}$ cm$^{-2}$ and arsenic ions at a dosage of not less than $2 \times 10^{15}$ cm$^{-2}$, and the transistor (305) in the peripheral circuit is provided with said LDD structure by doping phosphorus ions at a dosage of more than $2 \times 10^{13}$ cm$^{-2}$ and arsenic ions at a dosage of not less than $2 \times 10^{15}$ cm$^{-2}$.

6. A semi-conductor device as claimed in any preceding claim characterised in that the channel length of the transistor (106, 305) in the peripheral circuit is larger than the channel length of the transistor (105, 304) in the internal circuit.

7. A semi-conductor device having an internal circuit including a MOS transistor (105, 304) and a peripheral circuit including a MOS transistor (106, 305) characterised in that a drain diffusion layer (109, 303) of the transistor (106, 305) of the peripheral circuit has an impurity concentration which is higher than the impurity concentration of a drain diffusion layer (108, 302) of the transistor (105, 304) of the internal circuit.

8. A method of making a semi-conductor device as claimed in any preceding claim.

9. In a semi-conductor device having an internal circuit incorporating at least an N-channel MOS transistor and a peripheral circuit incorporating at least an N-channel MOS transistor, the improvement comprising a drain diffusion layer of said N-channel MOS transistor which is composed of arsenic and phosphorus and the phosphorus concentration of said N-channel transistor in said peripheral circuit which is higher than the phosphorus concentration of said N-channel transistor in said internal circuit.

FIG. 1

FIG. 2

FIG. 3

FIG.4

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | EP-A-0 189 914  (HITACHI) <br> * Page 7, lines 21-23; figures 1,2B,2E; page 15, lines 6-19; figure 3; page 12, lines 2-7; page 12, line 22 - page 13, line 15; page 3, lines 6-24 * <br> --- | 1-9 | H 01 L   29/784 <br> H 01 L   27/088 |
| A | EP-A-0 114 491  (FUJITSU) <br> * Abstract; figure 4F * <br> ----- | 6 | |

TECHNICAL FIELDS SEARCHED (Int. Cl.5)

H 01 L   29/00
H 01 L   27/00

The present search report has been drawn up for all claims

| Place of search | Date of completion of the search | Examiner |
|---|---|---|
| THE HAGUE | 26-09-1989 | ZEISLER P.W. |

EPO FORM 1503 03.82 (P0401)